Europäisches Patentamt

European Patent Office

Office européen des brevets

(11) Veröffentlichungsnummer: **0 239 158 B1**

# (12) EUROPÄISCHE PATENTSCHRIFT

(45) Veröffentlichungstag der Patentschrift: 25.09.91

(51) Int. Cl.⁵: **H05K 3/34**

(21) Anmeldenummer: **87200444.5**

(22) Anmeldetag: **10.03.87**

(54) **Leiterplatte für gedruckte Schaltungen und Verfahren zur Herstellung solcher Leiterplatten.**

(30) Priorität: **25.03.86 AT 791/86**

(43) Veröffentlichungstag der Anmeldung:
**30.09.87 Patentblatt 87/40**

(45) Bekanntmachung des Hinweises auf die
Patenterteilung:
**25.09.91 Patentblatt 91/39**

(84) Benannte Vertragsstaaten:
**AT BE CH DE FR GB LI NL**

(56) Entgegenhaltungen:
**DE-A- 2 154 958      DE-B- 1 187 282**
**FR-A- 2 551 618      GB-A- 2 032 190**
**US-A- 4 088 828      US-A- 4 104 111**
**US-A- 4 220 810      US-A- 4 413 309**

(73) Patentinhaber: **N.V. Philips' Gloeilampenfabrieken
Groenewoudseweg 1
NL-5621 BA Eindhoven(NL)**

(72) Erfinder: **Uggowitzer, Werner
c/o INT. OCTROOIBUREAU B.V. Prof. Holstlaan 6
NL-5656 AA Eindhoven(NL)**

(74) Vertreter: **Weening, Cornelis et al
INTERNATIONAAL OCTROOIBUREAU B.V.
Prof. Holstlaan 6
NL-5656 AA Eindhoven(NL)**

## Beschreibung

Die Erfindung betrifft eine Leiterplatte für gedruckte Schaltungen, bei der auf einer Isolierstoffplatte die gewünschten Leiterbahnen und Lötaugen in Form elektrisch leitfähiger Abschnitte vorgesehen sind und die Isolierstoffplatte und die Leiterbahnen unter Freistellung der Lötaugen mit einer lotabweisenden Lackmaske abgedeckt sind, wobei die Lackmaske aus zwei Lackschichten besteht, von denen eine Lackschicht zumindest einen Teil der anderen Lackschicht überdeckt. Bei einer solchen aus der US-PS 4 088 828 bekannten Leiterplatte ist die Lackmaske, vielfach auch Lötstoppmaske genannt, so ausgebildet, dass sie auch Teile der Lötaugen im Bereich ihrer Umrandungen abdeckt. Die Lackmaske besteht hierbei aus einer die Isolierstoffplatte, die Leiterbahnen und die vorgenannten Umrandungen der Lötaugen abdeckenden Lackschicht und einer dadarüber liegenden weiteren Lackschicht, die in jenen Bereichen der Leiterplatte angebracht ist, wo die Lötaugen sehr knapp nebeneinander liegen. Diese weitere, gegenüber der erstgenannten Lackschicht erhabene, zwischen zwei benachbarten Lötaugen einen Wall bildende Lackschicht dient dazu, dass beim Lötvorgang zwischen den benachbarten Lötaugen keine Lotbrücken entstehen. Bei einer solchen Lackmaske, die auch Teile der Lötaugen abdeckt, ist ein ganz besonders genaues Aufbringen der Lackmaske erforderlich, damit gewährleistet ist, dass diejenigen Bereiche der Lötaugen, wo der Lötvorgang erfolgen soll, auch wirklich freigestellt sind, damit eine sichere Lötverbindung entsteht. Die Einhaltung einer solchen hohen Genauigkeit beim Aufbringen der Lackmaske bereitet aber in der Praxis erhebliche Schwierigkeiten und erfordert komplizierte und aufwendige Methoden zum Aufbringen der Lackmaske. Man hat aber auch schon aus nur einer Lackschicht bestehende Lackmasken auf Isolierstoffplatten so aufgebracht, dass sie unter Abdeckung der Leiterbahnen gerade bis zu den Umrandungen der Lötaugen reichen, wie dies die DE-OS 29 37 886 zeigt. Auch hier erfordert das Aufbringen der Lackmaske eine hohe Genauigkeit und ist daher ebenfalls kompliziert und aufwendig. Um diese Schwierigkeiten zu vermeiden, werden einsichtige Lackmasken, wie allgemein bekannt, vielfach so aufgebracht, dass sie zur Freistellung der Lötaugen diese mit relativ grossem Abstand umranden. Dies bringt aber den Nachteil mit sich, dass die Bereiche der Isolierstoffplatte, die zwischen der Umrandung der Lötaugen und dem Rand der Lackmaske liegen, nicht abgedeckt sind.

Die Erfindung hat sich zum Ziel gesetzt, eine Leiterplatte der eingangs angeführten Gattung so auszubilden, dass bei sicherer Freistellung der gesamten Fläche der Lötaugen sowohl die Isolierstoffplatte als auch die Leiterbahnen einwandfrei abgedeckt sind. Erfindungsgemäss ist hierzu vorgesehen, dass mindestens im Bereich der Lötaugen eine bis an die Umrandungen der elektrisch leitfähigen Abschnitte heranreichende, unmittelbar die Isolierstoffplatte abdeckende Lackschicht vorgesehen ist und dass die andere Lackschicht unter Freistellung der Lötaugen die Leiterbahnen abdeckt und unter gegenseitiger Überdeckung bis in den Bereich der bis an die Umrandungen der elektrisch leitfähigen Abschnitte heranreichenden Lackschicht reicht. Auf diese Weise übernimmt eine Lackschicht die Abdeckung der Isolierstoffplatte bis zu den Umrandungen der Lötaugen hin und die andere Lackschicht unter Freistellung der Lötaugen die Abdeckung der Leiterbahnen, wobei durch die gegenseitige Überdeckung der beiden Lackschichten sichergestellt ist, dass auch alle Teile der Isolierstoffplatte einwandfrei abgedeckt sind. Hierbei kann die Freistellung der Lötaugen mit relativ grossem Abstand zwischen der Umrandung der Lötaugen und den Rand der die Leiterbahnen abdeckenden Lackschicht erfolgen, da die Isolierstoffplatte in diesem Bereich selbst durch die erstgenannte Lackschicht abgedeckt ist. Dabei bestehen beim Aufbringen der beiden Lackschichten keine Toleranzprobleme mehr und die einzuhaltenden Genauigkeiten sind unkritisch.

Als vorteilhaft hat sich erwiesen, wenn die bis an die Umrandungen der elektrisch leifähigen Abschnitte heranreichende Lackschicht die Isolierstoffplatte grossflächig abdeckt und von der anderen Lackschicht unter Freistellung der Lötaugen grossflächig überdeckt wird. Auf diese Weise wird das Aufbringen der Lackschichten einfach und unkritisch wobei durch die grossflächige gegenseitige Überdeckung der beiden Lackschichten erreicht ist, dass die Lackmaske unter sicherer Freistellung der Lötaugen die gesamte Leiterplatte einwandfrei abdeckt.

Ebenfalls als vorteilhaft hat sich erwiesen, wenn die andere Lackschicht unter Freistellung der Lötaugen die Leiterbahnen und die Isolierstoffplatte grossflächig abdeckt und von der bis an die Umrandungen der elektrisch leitfähigen Abschnitte heranreichenden Lackschicht zumindest teilweise überdeckt wird. Auch hierbei ergibt sich ein einfaches, unkritisches Aufbringen der Lackschichten, da die die Lötaugen freistellende Lackschicht in üblicher Weise mit relativ grossem Abstand die Lötaugen umrandend aufgebracht wird und die noch freien Teile der Isolierstoffplatte unter zumindest teilweise Überdeckung der die Lötaugen freistellende Lackschicht von der bis an die Umrandungen der Lötaugen heranreichenden Lackschicht abgedeckt werden. Auch hier wird wieder die Leiterplatte unter sicherer Freistellung der Lötaugen von der Lackmaske vollständig abgedeckt.

Weiters betrifft die Erfindung Verfahren zur Herstellung erfindungsgemäss ausgebildeter Leiterplatten. Bei diesen Verfahren werden auf einer Isolierstoffplatte die gewünschten Leiterbahnen und Lötaugen in Form elektrisch leitfähiger Abschnitte hergestellt, worauf unter Freistellung der Lötaugen die Isolierstoffplatte und die Leiterbahnen mit einer lotabweisenden Lackmaske abgedeckt werden, wie dies allgemein bekannt ist. Die Erfindung hat sich zum Ziel gesetzt, besonders einfache Verfahren zur Herstellung erfindungsgemässer Leiterplatten anzugeben.

Erfindungsgemäss ist hierzu nach einem ersten Verfahren vorgesehen, dass nach der Herstellung der Leiterbahnen und Lötaugen mindestens im Bereich der Lötaugen auf die Isolierstoffplatte und die elektrisch leitfähigen Abschnitte eine lotabweisende, ausschliesslich mit der Isolierstoffplatte eine fest haftende Verbindung eingehende Lackschicht aufgebracht wird, dass diese Lackschicht ausgehärtet wird, dass danach durch chemische Entfernung die Lackschicht von den elektrisch leitfähigen Abschnitten entfernt wird, dass anschliessend unter Freistellung der Lötaugen eine weitere lotabweisende, durchwegs eine fest haftende Verbindung eingehende, die elektrisch leitfähigen Abschnitte und die zuerst aufgebrachte Lackschicht teilweise überdeckende Lackschicht aufgebracht wird, welche die Lötaugen mit Abstand umrandet und die dann ausgehärtet wird, wonach die Leiterplatte in üblicher Weise fertiggestellt wird. Auf diese Weise ist das Aufbringen beider Lackschichten vollkommen unkritisch, da die zuerst aufgebrachte Lackschicht mindestens die Bereich der Lötaugen ganz überdeckt, wobei überhaupt keine Probleme hinsichtlich der einzuhaltenden Genauigkeit auftreten und beim Aufbringen der weiteren Lackschicht das Freistellen der Lötaugen mit einem relativ grossen Sicherheitsabstand erfolgen kann, so dass auch hierbei keine besonderen Genauigkeitsanforderungen bestehen. Durch die Verwendung zweier verschiedener Lackarten, von welchen die eine ausschliesslich mit der Isolierstoffplatte eine fest haftende Verbindung und die andere eine durchwegs fest haftende Verbindung eingeht, wird dabei erreicht, dass die mit der erstgenannten Lackart gebildete, die elektrisch leitfähigen Abschnitte und insbesondere die Lötaugen überdeckende Lackschicht wieder einfach auf chemischem Weg von den elektrisch leitfähigen Abschnitten und insbesondere den Lötaugen entfernt werden kann, wodurch sichergestellt ist, dass die von ihr verbleibende Lackschicht exakt bündig bis an die Umrandungen der elektrisch leitfähigen Abschnitte und insbesondere der Lötaugen heranreicht. Ein solches chemisches Entfernen einer Lackschicht wird bei der Herstellung von Leiterplatten veilfach angewandt und auch als Strippen bezeichnet. Durch die gegenseitige teilweise Überdeckung der beiden Lackschichten ist wieder erreicht, dass die Lackmaske bis auf die Lötaugen die Leiterplatte vollständig abdeckt.

Bei einem solchen Verfahren hat sich auch als vorteilhaft erwiesen, wenn nach der chemischen Entfernung der Lackschicht von den elektrisch leitfähigen Abschnitten die verbleibende Lackschicht nochmals ausgehärtet wird. Auf diese Weise ist sichergestellt, dass die auf der Isolierstoffplatte verbleibende Lackschicht tatsächlich einwandfrei ausgehärtet ist, da es bei der chemischen Entfernung der Lackschicht von den elektrisch leitfähigen Abschnitten gegebenenfalls zu einer Aufweichung der verbleibenden Lackschicht kommen kann.

Nach einem zweiten erfindungsgemässen Verfahren ist vorgesehen, dass nach der Herstellung der Leiterbahnen und der Lötaugen auf die Isolierstoffplatte und die Leiterbahnen unter Freistellung der Lötaugen eine lotabweisende, durchwegs eine fest haftende Verbindung eingehende Lackschicht aufgebracht wird, welche die Lötaugen mit Abstand umrandet, dass diese Lackschicht ausgehärtet wird, dass danach eine weitere lotabweisende, jedoch ausschliesslich mit der Isolierstoffplatte und der zuerst aufgebrachten Lackschicht eine fest haftende Verbindung eingehende, die Lötaugen, die noch freien Teile der Isolierstoffplatte und zumindest teilweise die zuerst aufgebrachte Lackschicht überdeckende Lackschicht aufgebracht und anschliessend ausgehärtet wird und dass dann durch chemische Entfernung die weitere Lackschicht von den Lötaugen entfernt wird, wonach die Leiterplatte in üblicher Weise fertiggestellt wird. Auf diese Weise ist wieder das Aufbringen beider Lackschichten vollkommen unkritisch, da hierbei keine besonderen Genauigkeitsanforderungen bestehen. Dabei ist durch die zumindest teilweise gegenseitige Überdeckung der beiden Lackschichten wieder gewährleistet, dass die ganze Isolierstoffplatte einwandfrei abgedeckt ist und die weitere Lackschicht exakt bündig bis an die Umrandungen der Lötaugen heranreicht. Auch bei diesem Verfahren ist wesentlich, dass zwei verschiedene Lackarten für die beiden Lackschichten verwendet werden, von welche die zuerst aufgebrachte Lackschicht eine durchwegs fest haftende Verbindung und die weitere Lackschicht eine ausschliesslich mit der Isolierstoffplatte und der zuerst aufgebrachten Lackschicht fest haftende Verbindung eingeht, damit die die Lötaugen überdeckende weitere Lackschicht wieder einfach chemisch von denselben entfernt werden kann.

Auch bei diesem Verfahren hat sich als vorteilhaft erwiesen, wenn nach der chemischen Entfernung der weiteren Lackschicht von den Lötaugen die verbleibende Lackschicht nochmals ausgehärtet wird. Damit ist wieder sichergestellt, dass die verbleibende Lackschicht einwandfrei ausgehärtet ist.

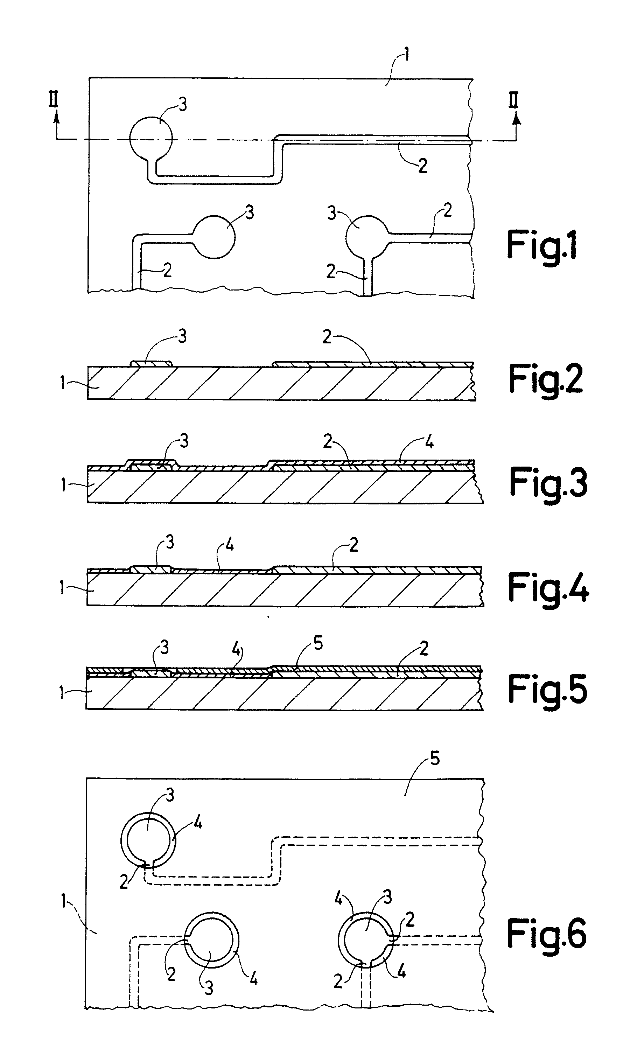

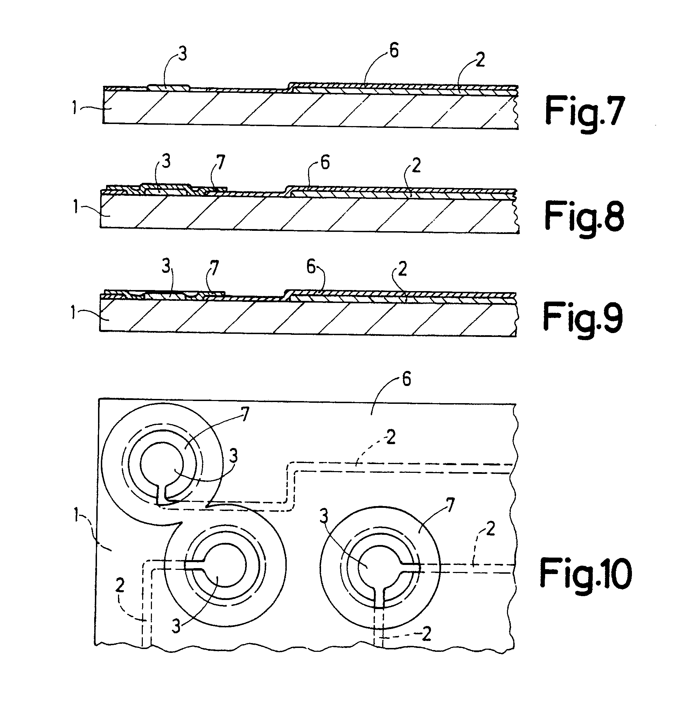

Die Erfindung wird im folgenden anhand der Zeichnungen, in welchen zwei Ausführungsbeispiele der Erfindung dargestellt sind und die zur Beschreibung zweier erfindungsgemässer Herstellungsverfahren dienen, auf die sie jedoch nicht beschränkt sein soll, näher erläutert. Fig. 1 zeigt in Draufsicht die mit den gewünschten Leiterbahnen und Lötaugen versehene Isolierstoffplatte einer Leiterplatte. Fig. 2 zeigt die Leiterplatte nach Fig. 1 im Schnitt nach der Linie II-II in Fig. 1. Zur Illustration eines ersten Verfahrens zur Herstellung einer erfindungsgemässen Leiterplatte zeigt Fig. 3 in der Darstellungsweise von Fig. 2 die Leiterplatte nach Fig. 2 mit einer aufgebrachten lotabweisenden Lackschicht, die ausschliesslich mit der Isolierstoffplatte eine fest haftende Verbindung eingeht. Fig. 4 zeigt in der Darstellungsweise von Fig. 2 die Leiterplatte nach Fig. 3, nachdem die aufgebrachte Lackschicht von den Leiterbahnen und Lötaugen chemisch entfernt wurde. Fig. 5 zeigt in der Darstellungsweise von Fig. 2 die Leiterplatte nach Fig. 4, nachdem unter Freistellung der Lötaugen eine durchwegs eine fest haftende Verbindung eingehende weitere lotabweisende Lackschicht aufgebracht wurde, welche im wesentlichen die Leiterbahnen und teilweise die zuerst aufgebrachte Lackschicht überdeckt. Fig. 6 zeigt die Leiterplatte nach Fig. 5 in Draufsicht. Zur Illustration eines zweiten Verfahrens zur Herstellung einer erfindungsgemässen Leiterplatte zeigt Fig. 7 in der Darstellungsweise von Fig. 2 die Leiterplatte nach Fig. 2 mit einer aufgebrachten lotabweisenden, die Lötaugen freistellenden Lackschicht, welche eine durchwegs fest haftende Verbindung eingeht. Fig. 8 zeigt in der Darstellungsweise von Fig. 2 die Leiterplatte nach Fig. 7, welche mit einer ausschliesslich mit der Isolierstoffplatte und der zuerst aufgebrachten Lackschicht eine fest haftende Verbindung eingehenden weiteren Lackschicht versehen ist, welche die Lötaugen, die noch freien Teile der Isolierstoffplatte und teilweise die zuerst aufgebrachte Lackschicht überdeckt. Fig. 9 zeigt in der Darstellungsweise von Fig. 2 die Leiterplatte nach Fig. 8, nachdem durch chemisch Entfernung die weitere Lackschicht von den Lötaugen entfernt wurde. Fig. 10 zeigt die Leiterplatte nach Fig. 9 in Draufsicht.

In den Figuren 1 und 2 ist mit 1 eine Isolierstoffplatte bezeichnet, auf der verschiedene, aus elektrisch leitfähigen Abschnitten bestehende Leiterbahnen 2 und Lötaugen 3 vorgesehen sind, die nach üblichen, zum Stand der Technik zählenden Verfahren auf der Isolierstoffplatte gebildet werden können. Anhand der Figuren 3 bis 6 wird nun ein Verfahren beschrieben, mit dem unter Freistellung der Lötaugen die Isolierstoffplatte 1 und die Leiterbahnen 2 mit einer lotabweisenden, aus zwei Lackschichten bestehenden Lackmasse abgedeckt werden, wobei eine Lackschicht der Lackmaske unmittelbar bis an die Umrandungen der Lötaugen 3 heranreicht, die Lötaugen selber aber vollkommen freigestellt sind. Nach einem ersten Verfahrensschritt wird hierzu die gesamte Leiterplatte nach den Figuren 1 und 2, also die Isolierstoffplatte, die Leiterbahnen und die Lötaugen, mit einer lotabweisenden Lackschicht 4 bedeckt, was beispielsweise in der bekannten Siebdrucktechnik geschehen kann. An sich könnte hierfür aber beispielsweise auch ein Photodruckverfahren herangezogen werden. Für diese Lackschicht 4 wird dabei eine Lackart verwendet, die ausschliesslich mit der Isolierstoffplatte eine fest haftende Verbindung eingeht und demgemäss auf den elektrisch leitfähigen Abschnitten, nämlich den Leiterbahnen 2 und Lötaugen 3, nicht fest haftet.

Bei solchen Lackarten handelt es sich um Lacke, die aufgrund ihrer Zusammensetzung die Eigenschaft haben, mit thermoplastischen organischen Kunststoffen, nicht aber mit Metallen, eine fest haftende Verbindung einzugehen. Zu derartigen Kunststoffen zählen auch Kleber, wie sie beim Kaschieren der Isolierstoffplatte mit dem elektrisch leitfähigen Laminat verwendet werden. Dieser auf der Isolierstoffplatte, auf dem von den elektrisch leitfähigen Abschnitten freien Stellen verbliebene Kleber bewirkt dann, dass die Lackschicht 4 auf der Isolierstoffplatte fest haftet. Ein lotabweisender Lack, welcher derartige Eigenschaften aufweist, ist beispielsweise von der Firma Pangolin unter der Typenbezeichnung 15.89/5 TA im Handel erhältlich. Es ist dies ein sogenannter UV-aushärtender Einkomponentenlack auf Acrylatbasis, der bei Bestrahlung mit ultraviolettem Licht aushärtbar ist, was auch nach dem Aufbringen dieser Lackschicht 4 durchgeführt wird. In einem daran anschliessenden Verfahrenschritt wird durch chemische Entfernung die Lackschicht 4 von den elektrisch leitfähigen Abschnitten, also den Leiterbahnen 2 und den Lötaugen 3 entfernt, wie dies Fig. 4 zeigt. Ein solches chemisches Entfernen der Lackschicht, das in der Leiterplattentechnologie auch als Strippen bezeichnet wird, kann dadurch geschehen, dass die Leiterplatte für eine vorgegebene Zeit in ein Kalilauge oder Natronlauge enthaltendes Bad getaucht wird. Bei diesem Vorgang verseift die Lackschicht 4 an den Stellen, wo sie nicht fest haftet, also den elektrisch leitfähigen Abschnitten, schneller als an den Stellen wo sie fest haftet, wodurch sie von den elektrisch leitfähigen Abschnitte abtragbar ist. Daran anschliessend wird zweckmässigerweise die nur noch auf der Isolierstoffplatte 1 verbliebene Lackschicht 4 nochmals ausgehärtet, um gegebenenfalls bei der chemischen Behandlung erweichte Bereiche dieser Lackschicht wieder zu festigen.

Auf diese Weise ist erreicht, dass die die Isolierstoffplatte 1 bedeckende Lackschicht 4 exakt bündig bis an die Umrandungen der elektrisch leitfähigen Abschnitte, insbesondere der Lötaugen 3, heranreicht. Wie ersichtlich, ist das Aufbringen der Lackschicht 4 vollkommen unkritisch, da sie einfach grossflächig auf die gesamte Leiterplatte aufgebracht wird. An sich wäre es aber auch möglich, die Lackschicht 4 nur jeweils im Bereich der Lötaugen 3 aufzubringen, wodurch Lackmaterial gespart werden könnte. Auch in einem solchen Fall wäre das Aufbringen der Lackschicht 4 vollkommen unkritisch, da die Lackbereiche die Lötaugen 3 mit grösserem Abstand umranden könnten, wobei diese Bereiche gegebenenfalls auch ineinander übergehend zusammenhängen könnten.

In einem nächsten Verfahrensschritt wird nun eine weitere lotabweisende Lackschicht 5 aufgebracht, welche unter Freistellung der Lötaugen 3 grossflächig die verbleibenden elektrisch leitfähigen Abschnitte, nämlich die wesentlichen Teile der Leiterbahnen 2, und die zuerst aufgebrachte Lackschicht 4 teilweise überdeckt, wobei die Lötaugen 3 von dieser Lackschicht 5 mit Abstand umrandet werden. Diese Lackschicht 5 deckt somit die Leiterbahnen 2 bis auf die Bereiche rund um die Lötaugen 3 ab. Für diese lotabweisende Lackschicht 5 wird dabei eine für lotabweisende Lackschichten übliche Lackart verwendet, welche durchwegs eine fest haftende Verbindung eingeht, also auch auf den Leiterbahnen 2 und der zuerst aufgebrachten Lackschicht 4 fest haftet. Ein lotabweisender Lack, welcher derartige Eigenschaften aufweist, ist beispielsweise von der Firma Dynachem unter der Typenbezeichnung SM 15 LV im Handel erhältlich. Es ist dies ebenfalls ein UV-aushärtender Einkomponentenlack auf Acrylatbasis, der bei Bestrahlung mit ultraviolettem Licht aushärtbar ist, was auch nach dem Aufbringen dieser Lackschicht 5 durchgeführt wird.

Wie ersichtlich, ist auch das Aufbringen der Lackschicht 5, was beispielsweise wieder im Siebdruckverfahren geschehen kann, hinsichtlich allfällig auftretender Toleranzen vollkommen unkritisch, da die Lackschicht 5 die Lötaugen 3 mit relativ grossem Abstand umranden kann, so dass keine besonderen Genauigkeitsanforderungen beim Aufbringen dieser Lackschicht 5 bestehen. Eine derartige Umrandung der Lötaugen 3 durch die Lackschicht 5 mit relativ grossem Abstand ist deshalb möglich, da in diesem Bereich die Isolierstoffplatte 1 bereits durch die lotabweisende Lackschicht 4 abgedeckt und damit geschützt ist. Auf diese Weise werden somit nur die Lötaugen 3 vollständig von Lackmaterial freigehalten. Hingegen werden durch die gegenseitigen Überdeckung der beiden Lackschichten 4 und 5 die verbleibenden Teile der Leiteplatte, wie gewünscht, von der Lackmaske vollständig und einwandfrei abgedeckt. Das Herstellungsverfahren ist dabei sehr einfach, da beim Aufbringen der Lackschichten keine besonderen Genauigkeitsanforderungen einzuhalten sind. Durch das grossflächige Aufbringen bei der Lackschicht 4 und 5 ist ihr Aufbringen einfach und durch die dabei entstehende grossflächige gegenseitige Überdeckung der beiden Lackschichten wird, bis auf die Lötaugen selbst, eine besonders einwandfreie Abdeckung der Leiterplatte durch die Lackmaske erreicht.

Nach dem Aufbringen der lotabweisenden Lackschicht 5 und dem Aushärten derselben wird dann die Leiterplatte in üblicher Weise fertiggestellt. Im Zuge dieser Fertigstellung kann die Leiterplatte mit einer Bedruckung versehen, die Lötaugen von Oxydschichten befreit, eine Schutzlackierung aufgebracht und die mechanische Bearbeitung, wie das Bohren oder Stanzen der Durchgangslöcher, vorgenommen werden.

Ein zweites Verfahren zur Herstellung einer Leiterplatte, die mit einer lotabweisenden Lackmaske versehen ist, die im Bereich der Lötaugen bis an deren Umrandung heranreicht, geht wieder von einer wie in den Figuren 1 und 2 dargestellten Leiterplatte aus, bei der auf einer Isolierstoffplatte 1 die Leiterbahnen 2 und die Lötaugen 3 in Form elektrisch leitfähiger Abschnitte vorgesehen sind. Auf eine derartige Leiterplatte wird auf die Isolierstoffplatte 1 und die Leiterbahnen 2 unter Freistellung der Lötaugen 3 eine lotabweisende, durchwegs eine fest haftende Verbindung eingehende Lackschicht 6 aufgebracht, welche somit die Lötaugen 3 mit Abstand umrandet, wie dies Fig. 7 zeigt. Der Abstand zwischen den Umrandung der Lötaugen 3 und dem Rand der die Lötaugen 3 umrandenden Lackschicht 6 wird dabei relativ gross gewählt, so dass das Aufbringen dieser Lackschicht 6 vollkommen unkritisch ist und keinen besonderen Genauigkeitsanforderungen unterliegt. Es handelt sich somit um das Aufbringen einer lotabweisenden Lackschicht im allgemein üblicher Technik.

Nach dem Aushärten dieser Lackschicht 6 wird eine weitere lotabweisende, jedoch ausschliesslich mit der Isolierstoffplatte 1 und der zuerst aufgebrachten Lackschicht 6 eine fest haftende Verbindung eingehende Lackschicht 7 aufgebracht, welche die Lötaugen 3, die noch freien Teile der Isolierstoffplatte 1 und zumindest teilweise die zuerst aufgebrachte Lackschicht 6 überdeckt, wie dies Fig. 8 zeigt. Für die Wahl der Lackart für diese Lackschicht 7 gelten dabei die gleichen Gesichtspunkte wie für die Wahl der Lackschicht 4, bei dem zuvor beschriebenen Verfahren. Die ausschliesslich mit der Isolierstoffplatte 1 und der zuerst aufgebrachten Lackschicht 6 fest haftende Verbindung der Lackschicht 7 kommt dabei wieder dadurch zustande, dass für sie eine Lackart verwendet wird, die mit thermoplastischen organischen Kunststoffen, wozu auch die üblicherweise für die Lackschicht 6 verwendeten Lacke zählen, nicht aber mit Metallen, eine fest haftende Verbindung eingehen. Beim vorliegenden Ausführungsbeispiel ist diese Lackschicht 7 nur im Bereich der Lötaugen 3 angeordnet, um Lackmaterial zu sparen. Falls erwünscht, könnte aber auch die gesamte Leiterplatte nach Fig. 7 grossflächig mit der Lackschicht 7 abgedeckt werden. Nach dem Aushärten der Lackschicht 7 wird diese weitere Lackschicht durch eine, wie bereits beschriebene, chemische Behandlung von den Lötaugen 3 entfernt, was wieder dadurch möglich ist, dass für diese Lackschicht 7 eine Lackart verwendet wird, die ausschliesslich mit der Isolierstoffplatte 1 und der zuerst aufgebrachten Lackschicht 6 eine fest haftende Verbindung eingeht und somit auf den nicht von der Lackschicht 6 abgedeckten Teilen der elektrisch leitfähigen Abschnitte, hier im wesentlichen den Lötaugen 3, nicht fest haftet. Die auf diese Weise erhaltende Leiterplatte ist in den Figuren 9 und 10 dargestellt.

Zweckmässigerweise wird nach der chemischen Behandlung wieder ein Aushärten vorgenommen, damit sichergestellt ist, dass die verbleibende Lackschicht 7 einwandfrei ausgehärtet ist. Daran anschliessend wird die Leiterplatte in üblicher Weise fertiggestellt.

Auf diese Weise ist wieder erreicht, dass eine Lackschicht der Lackmaske, im vorliegenden Fall die weitere Lackschicht 7, exakt bündig bis an die Umrandung der Lötaugen 3 heranreicht und weiters durch die zumindest teilweise gegenseitige Überdeckung der beiden Lackschichten 6 und 7 die verbleibenden Teile der Leiterplatte einwandfrei abgedeckt sind. Wie ersichtlich, ist das Aufbringen der beiden Lackschichten 6 und 7 wieder vollkommen unkritisch, da hierbei keine besonderen Genauigkeitsanforderungen einzuhalten sind, wodurch sich auch dieses Verfahren zur Herstellung der Leiterplatte sehr einfach gestaltet.

**Patentansprüche**

1. Leiterplatte für gedruckte Schaltungen, bei der auf einer Isolierstoffplatte die gewünschten Leiterbahnen und Lötaugen in Form elektrisch leitfähiger Abschnitte vorgesehen sind und die Isolierstoffplatte und die Leiterbahnen unter Freistellung der Lötaugen mit einer lotabweisenden Lackmaske abgedeckt sind, wobei die Lackmaske aus zwei Lackschichten besteht, von denen eine Lackschicht zumindest einen Teil der anderen Lackschicht überdeckt, dadurch gekennzeichnet, dass mindestens im Bereich der Lötaugen eine bis an die Umrandungen der elektrisch leitfähigen Abschnitte heranreichende, unmittelbar die Isolierstoffplatte abdeckende Lackschicht vorgesehen ist und dass die andere Lackschicht unter Freistellung der Lötaugen die Leiterbahnen abdeckt und unter gegenseitiger Überdeckung bis in den Bereich der bis an die Umrandungen der elektrisch leitfähigen Abschnitte heranreichenden Lackschicht reicht.

2. Leiterplatte nach Anspruch 1, dadurch gekennzeichnet, dass die bis an die Umrandungen der elektrisch Leitfähigen Abschnitte heranreichende Lackschicht die Isolierstoffplatte grossflächig abdeckt und von der anderen Lackschicht unter Freistellung der Lötaugen grossflächig überdeckt wird.

3. Leiterplatte nach Anspruch 1, dadurch gekennzeichnet, dass die andere Lackschicht unter Freistellung der Lötaugen die Leiterbahnen und die Isolierstoffplatte grossflächig abdeckt und von der bis an die Umrandungen der elektrisch leitfähigen Abschnitte heranreichenden Lackschicht zumindest teilweise überdeckt wird.

4. Verfahren zur Herstellung einer Leiterplatte für gedruckten Schaltungen nach Anspruch 1 oder 2, bei dem auf einer Isolierstoffplatte die gewünschten Leiterbahnen und Lötaugen in Form elektrisch leitfähiger Abschnitte hergestellt werden, worauf unter Freistellung der Lötaugen die Isolierstoffplatte und die Leiterbahnen mit einer lotabweisenden Lackmaske abgedeckt werden, dadurch gekennzeichnet, dass nach der Herstellung der Leiterbahnen und Lötaugen mindestens im Bereich der Lötaugen auf die Isolierstoffplatte und die elektrisch leitfähigen Abschnitte eine lotabweisende, ausschliesslich mit der Isolierstoffplatte eine fest haftende Verbindung eingehende Lackschicht aufgebracht wird, dass diese Lackschicht ausgehärtet wird, dass danach durch chemische Entfernung die Lackschicht von den elektrisch leitfähigen Abschnitten entfernt wird, dass anschliessend unter Freistellung der Lötaugen eine weitere lotabweisende, durchwegs eine fest haftende Verbindung eingehende, die elektrisch leitfähige Abschnitte und die zuerst aufgebrachte Lackschicht teilweise überdeckende Lackschicht aufgebracht wird, welche die Lötaugen mit Abstand umrandet und die dann ausgehärtet wird, wonach die Leiterplatte in üblicher Weise fertiggestellt wird.

5. Verfahren nach Anspruch 4, dadurch gekennzeichnet, dass nach der chemischen Entfernung der Lackschicht von den elektrisch leitfähigen Abschnitten die verbleibende Lackschicht nochmals ausgehärtet wird.

6. Verfahren zur Herstellung einer Leiterplatte für gedruckte Schaltungen nach Anspruch 1 oder 3, bei dem auf einer Isolierstoffplatte die gewünschen Leiterbahnen und Lötaugen in Form elektrisch leitfähiger Abschnitte hergestellt werden, worauf unter Freistellung der Lötaugen die Isolierstoffplatte und die Leiterbahnen mit einer lotabweisenden Lackmaske abgedeckt werden, dadurch gekennzeichnet, dass nach der Herstellung der Leiterbahnen und Lötaugen auf die Isolierstoffplatte und die Leiterbahnen unter Freistellung der Lötaugen eine lotabweisende, durchwegs eine fest haftende Verbindung eingehende Lackschicht, aufgebracht wird, welche die Lötaugen mit Abstand umrandet, dass diese Lackschicht ausgehärtet wird, dass danach eine weiterer lotabweisende, jedoch ausschliesslich mit der Isolierstoffplatte und der zuerst aufgebrachten Lackschicht eine fest haftende Verbindung eingehende, die Lötaugen, die noch freien Teile der Isolierstoffplatte und zumindest teilweise die zuerst aufgebrachte Lackschicht überdeckende Lackschicht aufgebracht und anschliessend ausgehärtet wird und dass dann durch chemische Entfernung die weitere Lackschicht von den Lötaugen entfernt wird, wonach die Leiterplatte in üblicher Weise fertiggestellt wird.

7. Verfahren nach Anspruch 6, dadurch gekennzeichnet, dass nach der chemischen Entfernung der weiteren Lackschicht von den Lötaugen die verbleibende Lackschicht nochmals ausgehärtet wird.

**Claims**

1. Printed circuit board in which the desired conductor tracks and solder lands are provided in the form of electrically conductive sections on an insulator plate and in which the insulator plate and the conductor tracks, though not the lands, are masked with a solder-repellent lacquer mask, the lacquer mask consisting of two layers of lacquer, one layer of which covers at least part of the other lacquer layer, characterized in that one lacquer layer extending to the edges of the electrically conductive sections and directly masking the insulator plate is provided at least in the region of the lands and the other lacquer layer, leaving the lands unmasked, masks the conductor tracks and extends to the region occupied by the lacquer layer extending to the edges of the electrically conductive sections, the two layers overlapping.

2. Printed circuit board as claimed in Claim 1, characterized in that the lacquer layer extending to the edges of the electrically conductive sections extensively masks the insulator plate and is extensively covered by the other lacquer layer, the lands being left uncovered.

3. Printed circuit board as claimed in Claim 1, characterized in that the other lacquer layer, leaving the lands uncovered, extensively masks the conductor tracks and the insulator plate and is at least partially covered by the lacquer layer extending to the edges of the electrically conductive sections.

4. Method of manufacturing a printed circuit board as claimed in Claim 1 or 2, in which the desired conductor tracks and lands in the form of electrically conductive sections are manufactured on an insulator plate, whereupon the insulator plate and the conductor tracks, though not the lands, are masked with a solder-repellent lacquer mask, characterized in that after the conductor tracks and lands have been manufactured a solder-repellent lacquer layer which bonds firmly only to the insulator plate is applied to the insulator plate and the electrically conductive sections, at least in the region of the lands, in that this lacquer layer is cured, in that the lacquer layer is then removed from the electrically conductive sections by chemical means, in that next a further solder-repellent lacquer layer which bonds firmly and indiscriminately is applied so as to partially cover the electrically conductive sections and the lacquer layer first applied, to leave the lands uncovered and to surround them with an interspace, and is then cured, whereupon the printed circuit board is completed in the usual manner.

5. Method as claimed in Claim 4, characterized in that after the chemical removal of the lacquer layer from the electrically conductive sections the remaining lacquer layer is cured again.

6. Method of manufacturing a printed circuit board as claimed in Claim 1 or 3, in which the desired conductor tracks and lands in the form of electrically conductive sections are manufactured on an insulator plate, whereupon the insulator plate and the conductor tracks, though not the lands, are masked by a solder-repellent lacquer mask, characterized in that after the conductor tracks and the lands have been manufactured a solder-repellent lacquer layer which bonds firmly and indiscriminately is applied to the insulator plate and the conductor tracks, the lands being left unmasked, and surrounds the lands with an interspace, in that this lacquer layer is cured, in that next a further solder-repellent lacquer layer which, however, bonds firmly only to the insulator plate and the lacquer layer first applied and which covers the lands, the parts of the insulator plate still unmasked and at least partially the lacquer layer first applied is applied and then cured, and in that then the further lacquer layer is removed from the lands by chemical means, whereupon the printed circuit board is completed in the usual manner.

7. Method as claimed in Claim 6, characterized in that after the chemical removal of the further lacquer layer from the lands, the remaining lacquer layer is cured again.

**Revendications**

1. Plaque de circuit pour des circuits imprimés comportant une plaque en matière isolante sur laquelle sont prévues les pistes conductrices et les points de soudage souhaités sous forme de segments électroconducteurs, la plaque en matière isolante et les pistes conductrices étant recouvertes, à l'exception des points de soudage, d'un masque en vernis antisoudage, le masque en vernis étant constitué par deux couches de vernis dont l'une recouvre au moins partiellement l'autre, caractériséé en ce qu'au moins dans la zone des points de soudage est prévue une couche de vernis s'étendant jusqu'aux bords des segments électroconducteurs et recouvrant immédiatement la plaque en matière isolante et en ce que l'autre couche de vernis recouvre, tout en laissant découverts les points de soudage, les pistes conductrices et les recouvre des deux côtés jusque dans la zone de la couche de vernis s'étendant jusqu'aux bords des segments électroconducteurs.

2. Plaque de circuit selon la revendication 1, caractérisé en ce que la couche de vernis s'étendant jusqu'aux bords des segments électroconducteurs recouvre en majeure partie la plaque en matière isolante et est recouverte en majeure partie par l'autre couche de vernis tout en laissant découverts les points de soudage.

3. Plaque de circuit selon la revendication 1, caractérisée en ce que l'autre couche de vernis recouvre en majeure partie les pistes conductrices et la plaque en matière isolante tout en laissant découverts les points de soudage et est recouverte, au moins partiellement, par la couche de vernis s'étendant jusqu'aux bords des segments électroconducteurs.

4. Procédé pour la fabrication d'une plaque de circuit pour des circuits imprimés selon la revendication 1 ou 2, selon lequel les pistes conductrices et les points de soudage souhaités sous forme de segments électroconducteurs sont réalisés sur une plaque en matière isolante, après quoi la plaque isolante et les pistes conductrices sont recouvertes d'un masque en vernis antisoudage à l'exception des points de soudage, caractérisé en ce qu'après la réalisation des pistes conductrices et des points de soudage, au moins dans la zone des points de soudage, une couche en vernis antisoudage qui n'engage une liaison fortement adhérente qu'avec la plaque en matière isolante est appliquée sur ladite plaque en matière isolante et les segments électroconducteurs, ladite couche en vernis étant durcie, après quoi la couche en vernis est enlevée des segments électroconducteurs par voie chimique, après quoi est appliquée, tout en laissant découverts les points de soudage, une autre couche en vernis antisoudage engageant sans exception une liaison fortement adhérente et recouvrant partiellement les segments électroconducteurs et la couche en vernis appliquée en premier lieu tout en entourant les points de soudage à une certaine distance, cette deuxième couche étant ensuite durcie, après quoi la plaque de circuit est finie de façon usuelle.

5. Procédé selon la revendication 4, caractérisé en ce qu'après l'enlèvement chimique de la couche en vernis des segments électroconducteurs, la couche en vernis qui subsiste est durcie encore une fois.

6. Procédé pour la fabrication d'une plaque de circuit pour des circuits imprimés selon la revendication 1 ou 3, selon lequel les pistes conductrices souhaitées et les points de soudage sous forme de segments électroconducteurs sont réalisés sur une plaque en matière isolante, après quoi, tout en laissant découverts les points de soudage, la plaque en matière isolante et les pistes conductrices sont recouvertes d'un masque en vernis antisoudage, caractérisé en ce qu'après la réalisation des pistes conductrices et des points de soudage sur la plaque en matière isolante et les pistes conductrices est appliquée, de façon à laisser découverts les points de soudage, une couche en vernis antisoudage engageant une liaison fortement adhérente et entourant à une certaine distance les points de soudage, ladite couche en vernis est durcie, après quoi est appliquée une autre couche en vernis antisoudage, engageant une liaison fortement adhérente avec uniquement la plaque en matière isolante et la couche en vernis appliquée en premier lieu et recouvrant les points de soudage, la partie encore découverte de la plaque en matière isolante et au moins partiellement la couche en vernis appliquée en premier lieu, après quoi l'autre couche est durcie et enlevée des points de soudage par voie chimique et ensuite la plaque de circuit est finie de façon usuelle.

7. Procédé selon la revendication 6, caractérisé en ce qu'après l'enlèvement chimique de l'autre couche en vernis des points de soudage, la couche en vernis subsistante est durcie encore une fois.

Fig.1

Fig.2

Fig.3

Fig.4

Fig.5

Fig.6

Fig.7

Fig.8

Fig.9

Fig.10